# EUROPEAN PATENT APPLICATION

(11) **EP 4 607 213 A1**
(43) Date of publication of application: **27.08.2025**
(21) Application number: 24305290.9
(22) Date of filing: 22.02.2024
(51) Int. Cl.: G01R 31/28, G01R 31/66, G01R 31/70, G01R 31/54, G01R 35/00

(54) **CIRCUIT AND METHOD FOR DETECTION OF FAILURE IN THE CIRCUIT**

(71) Applicant: NXP B.V., 5656 AG Eindhoven (NL)
(72) Inventor: El Ozeir, Mohamad, 31023 Toulouse (FR); Arbouet, Jeremie, 31023 Toulouse (FR); Pavao Moreira, Cristian, 31023 Toulouse (FR)
(74) Representative: Hardingham, Christopher Mark

(57) **Abstract**

A circuit a method for testing failure of a connection between a radio frequency, RF, integrated circuit and external circuitry is described. The circuit comprising: a first amplifier having an input path and an output path; a second amplifier having an input path and an output path; a combiner for combining the signal from the output path of the first amplifier and the output path of the second amplifier; a coupler for receiving the output of the combiner; and a power detector coupled to the output of the coupler, the combiner configured to send signals to the external circuitry, wherein the power detector receives a reflected voltage from the external circuitry, and determines that there is a connection failure between the RF circuit and the external circuitry when the reflected voltage exceeds a preset threshold voltage.

## Description

### FIELD OF THE INVENTION

The embodiments of the present disclosure relates to circuitry and a method for detection of failure in an integrated circuit

### BACKGROUND OF THE INVENTION

A Radar system can be used to detect, track and identify objects, and can also be used to determine parameters such as speed, distance and direction for oncoming objects and vehicles. In applications such as automotive radar, safety is a key requirement of the system. A non-functioning radar could lead to accidents. One of the possible failures is a package ball and/or solder joint break. If there is a breakage somewhere within the circuitry, this needs to be quickly detected so that a decision can be taken on whether or not to disable the overall system. An example of a system where fault detection capability is important is a car-radar module that may be used as part of an autonomous emergency braking system. Such a radar system detects if the vehicle is on a collision course with another vehicle or a pedestrian, and emits an early warning to the driver, and may also cause a controller to apply the brakes if the driver does not react. This is clearly a safety critical system, and erroneous decisions may have severe consequences, both for fail negative and false positive situations.

In a radar device, one or more radio frequency (RF) integrated circuits ('chips') are provided in a semiconductor die, the RF chips are typically connected to external circuitry via ball bonds or other connectors.

US11018635 describes a device 100 that is used to detect connection failure in a radar system. FIG. 1 is an example of an integrated circuit 101, a package 102 and a printed circuit board (PCB) 104 from this prior art. The circuit includes switches 130, 132 that are used to disable output paths 106, 107, where the switches are located between a power amplifier 105, and differential power detectors 108, 109 in each of the output paths 106, 107. In normal operation of the device 100, switches 130, 132 are closed and the differential outputs 106, 107 of the power amplifier 105 are connected to the differential power detectors 108, 109. By looping the RF signal from one pathway to another through the utilization of an external balun/combiner 110 as a path, the prior art describes a circuit and methodology that employs switches and multiple power detectors to identify failures in the connection between the IC and external circuitry.

Traditional ball break methods rely on DC current measurements, which may be ineffective in pinpointing RF-related issues

Accordingly, there is a need for a circuit and method for detection of communication failure in the circuit.

### SUMMARY OF THE INVENTION

The present invention provides a circuit for detecting connection failure and a method therefor, as described in the accompanying claims. Specific embodiments are set forth in the dependent claims. These and other aspects will be apparent from and elucidated with reference to the embodiments described hereinafter.

### BRIEF DESCRIPTION OF THE DRAWINGS

Further details, aspects and embodiments will be described, by way of example only, with reference to the drawings. In the drawings, like reference numbers are used to identify like or functionally similar elements. Elements in the figures are illustrated for simplicity and clarity and have not necessarily been drawn to scale.

Because the illustrated examples may, for the most part, be implemented using electronic components and circuits known to those skilled in the art, details will not be explained in any greater extent than that considered necessary as illustrated below, for the understanding and appreciation of the underlying concepts of the present invention and in order not to obfuscate or distract from the teachings of the present invention.

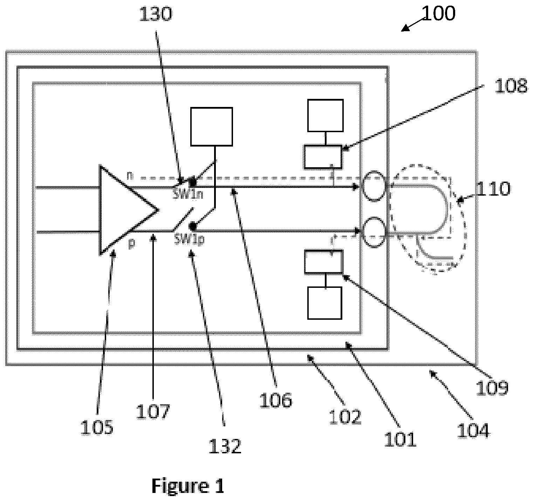

FIG. 1 illustrates a simplified known drawing of prior art circuit for detecting a connection failure;
FIG. 2 illustrates a circuit for failure detection, according to a first aspect;
FIG. 3 illustrates a circuit for failure detection according to a further aspect;
FIG.4 illustrates a circuit for failure detection and power calibration according to an aspect;
FIG. 5 illustrates a flow chart for performing a safety check of the circuit of FIG. 2 or 3;
FIG. 6 illustrates a flow chart showing circuit operations performed in the circuit of FIG. 2 or 3;
FIGs. 7(a) and 7(b) show Smith charts for different transmitters in a circuit.

### DETAILED DESCRIPTION

Because the illustrated examples of the present invention may, for the most part, be implemented using electronic components and circuits known to those skilled in the art, details will not be explained in any greater extent than that considered necessary as illustrated below, for the understanding and appreciation of the underlying concepts of the present invention and in order not to obfuscate or distract from the teachings of the present invention.

The key elements are to provide a circuit and a method to detect a connection failure in the package, solder joint, ball bonds or printed circuit board (PCB) of an integrated circuit element, such as a differential transmitter or a quadrature transmitter.

The circuit as described does not require the utilization of RF switches for detecting connection failures. These switches are recognized for their substantial insertion loss, rendering them unsuitable. Additionally, the circuit as described relies on the reflected signal rather than the incident signal. Traditional ball break methods rely on DC current measurements, which may be ineffective in pinpointing RF-related issues. This approach employs RF signal analysis for a thorough evaluation of the antenna system's performance, allowing the detection of even subtle disruptions in the RF signals.

Although examples are described with reference to Automated Test Equipment or Radar modules, it is envisaged that the circuit and method may be used in other examples.

In accordance with some examples, a circuit for testing failure of a connection between a radio frequency, RF, integrated circuit and external circuit is provided. The circuit comprises: a first amplifier having an input path and an output path; a second amplifier having an input path and an output path; a combiner for combining the signal from the output path of the first amplifier and the output path of the second amplifier; a coupler for receiving the output of the combiner; a power detector coupled to the output of the coupler, the combiner configured to send signals to the external circuitry, wherein the power detector receives a reflected voltage from the external circuitry and determines if there is a failure connection between the RF circuit and the external circuitry if the reflected voltage exceeds a preset threshold voltage.

An example further provides a method for testing a connection between a radio frequency, RF, integrated circuit and external circuitry, the circuit comprising: a first amplifier having first and second input paths and an output path; a second amplifier having first and second input paths and an output path; a combiner for combining the signal from the output path of the first amplifier and the output path of the second amplifier; a coupler for receiving the output of the combiner; a power detector coupled to the output of the coupler. The method comprising: the first and second amplifiers sending signals to the external circuitry, wherein the power detector is configured for receiving a reflected voltage from the external circuitry and determining if there is a failure connection between the RF circuit and the external circuitry if the reflected voltage exceeds a preset threshold voltage.

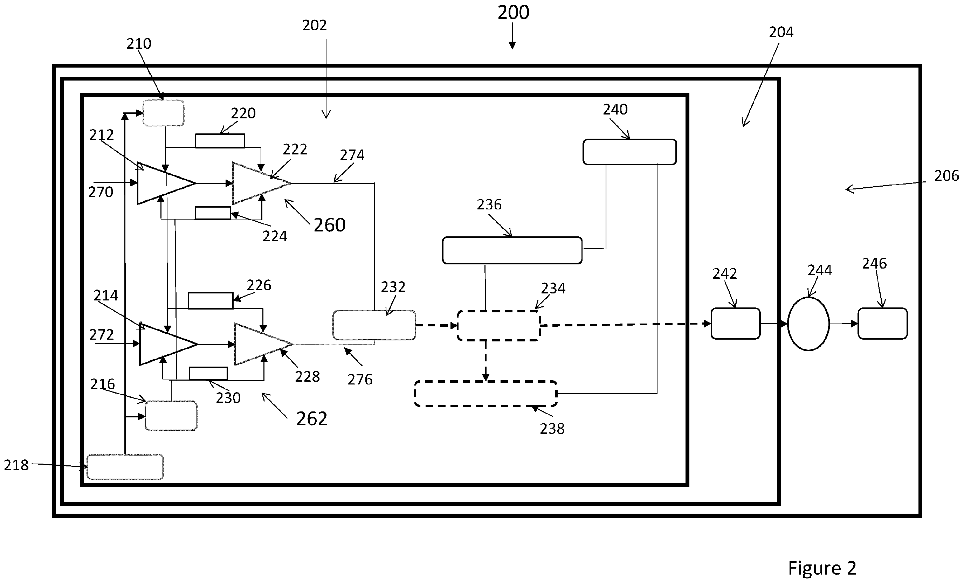

FIG. 2 shows an example circuit 200 according to a first aspect. As shown, the circuit 200 comprises an integrated circuit 202 containing first and second transmitters 260, 262, a package 204 and a PCB component 206. The integrated circuit 202 has assorted components as shown. The first transmitter 260 comprises driver 212 and first output amplifier 222, as well as voltage supply 220 and bias current supply 224. The second transmitter 262 has a driver 214 and amplifier 228, as well as voltage supply 226 and bias current supply 230. A control unit 218 is connected to one or more of drivers 212 and 214 of the first and second transmitters 260, 262. RF power from an RF buffer is provided via 270, 272 to drivers 212 and 214. Voltage regulator 210 is shown providing a voltage to driver 212 and to first output amplifier 222. Preferably the voltage regulator is a low drop out voltage regulator. There is a voltage supply 220 connected to driver 212 and first output amplifier 222. Bias current 224 is shown, with input to driver 212 and amplifier 222. Driver 214 is connected to second output amplifier 228, and there is a voltage supply 226 connected to driver 214 and second output amplifier 228. Preferably, the control unit 218 is provided for controlling one of more of the first and second drivers 212, 214 and the first and second output amplifiers. 222, 228. Bias current 230 is connected to driver 214 and output amplifier 228. Digital to analog converter (DAC) 216 is connected to and provides a bias current to the input of driver 214.

The outputs from output amplifiers 222 and 228 are provided via 274 and 276 to combiner 232, which provides a combined output to coupler 234, which then provides an isolated output to a detector circuit 238, and a coupled output to a detector circuit 236. Preferably, one or more of the detector circuits is a peak power detector. Preferably, the coupler 234 is a bi-directional coupler. The detector circuit 236 is connected to Variable Gain Amplifier (VGA) 240.

The integrated circuit 202 is connected to the package 204 via a balun 242. The balun 242 is connected via a ball bond 244 to the PCB 206, and the ball bond 244 is further connected to an Antenna Reference Plane (ARP) 246. As described above, the circuit allows for the detection of ball bond failures, but is applicable to failure connections more generally, such as ball break failure, PCB degradation failure, antenna failure, balun failure or external matching elements failure.

In operation of the circuit 200, an RF output signal is sent from each output amplifier 222, 228 of the first and second transmitters 260, 262 to the antenna reference plane 246 in the PCB 206. Preferably the output signals from the output amplifiers are sent simultaneously through the connection between the integrated circuit 202 and the PCB 206, and the reflected voltage from the PCB 206 that is received at the detector circuit 238 is reviewed to determine if there is a failure connection on the circuit 200. One or more of transmitter 260, 262 may provide a signal to bi-directional coupler 234 and onto ARP 246. As the signal is provided through these components, a reflected signal may be sent back from ARP 246 toward one or more of transmitters 260, 262. Bi-directional coupler 234 may separate the incident, or originally transmitted, signal from the reflected signal. Bi-directional coupler 234 may provide the incident signal to detector circuit 238, and provide the reflected signal to detector circuit 236. In certain examples, detector circuit 236 may be a peak power detector (PPD) circuit and may be coupled to the output of transmitter 262, 260. Detector circuit 236 may detect or determine the amplitude of the output signal from transmitter 260, 262. Detector circuit 238 may be a PPD circuit and may be isolated from the output of transmitter 260, 262. Detector circuit 238 may detect or determine the amplitude of the reflected signal.

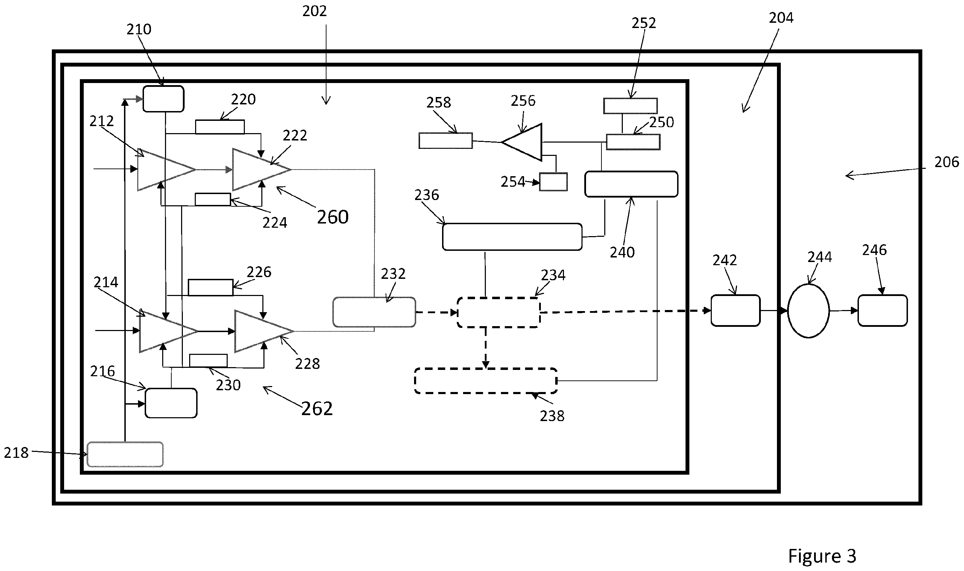

FIG. 3 is similar to FIG. 2 but also shows a memory 254 and other components required for real time monitoring of the signals to determine if there is a failure connection somewhere on the device. This example shows an Analogue to Digital Converter (ADC) 250 connected to the output of the VGA 240, to measure the output voltage of the VGA, and a digital input 252 connected to the output of the ADC 250. There is also a real time monitor 256 which receives a first input from the memory 254 and a second input from the ADC 250, and provides an output as a flag to Internal Safety Monitor 258. The VGA 240 will receive a reflected voltage detected by the detector circuit 238 connected to the isolated output of the bi-directional coupler 234. It will then transmit this voltage to the real-time monitor 256. The second input of the real time monitor 256 is connected to the memory 254, where various preset thresholds are stored based on the calibrated output power level. The real time monitor 256 compares the detected voltage to the threshold and determines whether a failure is occurring. Preferably, the failure is at least one of: ball break failure, PCB degradation failure, antenna failure, balun failure or external matching elements failure. In the event of a failure, the output of the real time monitor may be provided as a flag to the internal safety monitor 258.In some examples, this can be used to alert the user of the connection failure.

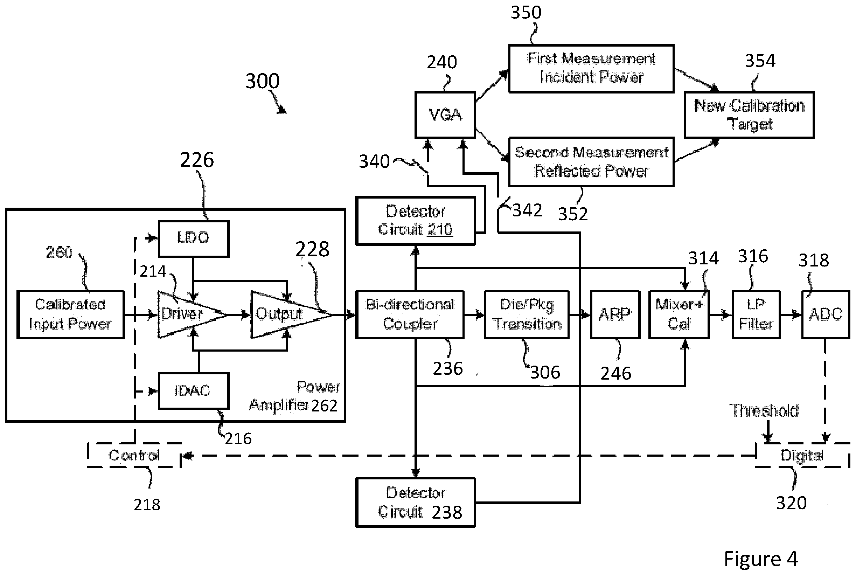

FIG. 4 shows circuitry 300 that may also be used to perform output power calibration in accordance with an example. Elements that are common to circuit 200 of FIG's 2 and 3 have been given the same reference numbers. The calibration may be performed using any of the elements of circuit 200, but is described with reference to circuit 300. Circuit 300 includes a transmitter 262, a bidirectional coupler 234, an antenna reference plane (ARP) 246, and detector circuits 236 and 238. Circuitry 200 further includes a mixer and calibration circuit 314, a lowpass (LP) filter 316, and analog-to-digital (ADC) converter 318, a digital comparator 320, a control circuit 218, and a voltage gain amplifier (VGA) 240. Transmitter 262 includes a driver 214, an output 228, a low dropout (LDO) circuit 226 and a current digital-to-analog circuit (iDAC) 216. The functions and features of transmitter 262, bi-directional coupler 234, die/package transition 306, and ARP 246 are known in the art and will not be further disclosed herein, except as needed to illustrate the various examples disclosed herein. Circuitry 300 may also include additional components that are not shown without varying from the scope of this disclosure.

Transmitter 262 may provide an output signal to bi-directional coupler 234 and die/package transition 306 to ARP 246. As the signal is provided through these components, a reflected signal may be sent back from the ARP 246 toward the transmitter 262. Bi-directional coupler 234 may separate the incident, or originally transmitted, signal from the reflected signal. Bi-directional coupler 234 may provide the incident signal to detector circuit 236, and provide the reflected signal to detector 238. In certain examples, detector circuit 236 may be a PPD circuit and may be coupled to the output of transmitter 262. Detector circuit 236 may detect or determine the amplitude of the output signal from transmitter 262. Detector circuit 238 may be a PPD circuit and may be isolated from the output of transmitter 262. Detector circuit 238 may detect or determine the amplitude of the reflected signal.

Detector circuits 236 and 238 may be coupled to VGA 240 through respective switches 340 and 342 in the communication paths between the detector circuits and the VGA 240. One of the switches 340 and 342 may be closed while the other switch is open, such that only one of the determined amplitudes is provided to VGA 240 at a time. For example, switch 340 may be closed and switch 342 may be open, such that VGA 240 may measure incident power 350. Next, switch 340 may be open and switch 342 may be closed, such that VGA 240 may measure reflected power 352. Based on measured incident power 350 and measured reflected power 352, a new calibration target 354 may be calculated for transmitter 262. In an example, the calibration target 354 may be calculated based on a previous calibration target being added to the output voltage from detector circuit 238. The new calibration target 354 may be utilized as a calibrated input power 360 provided to driver 214 of transmitter 262.

Bi-directional coupler 234 may provide the incident signal and the reflected signal to the mixer and calibration circuit 314. In response to receiving the incident and reflected signals, the calibration portion of the mixer and calibration circuit 314 may determine and output a phase difference between the two signals.

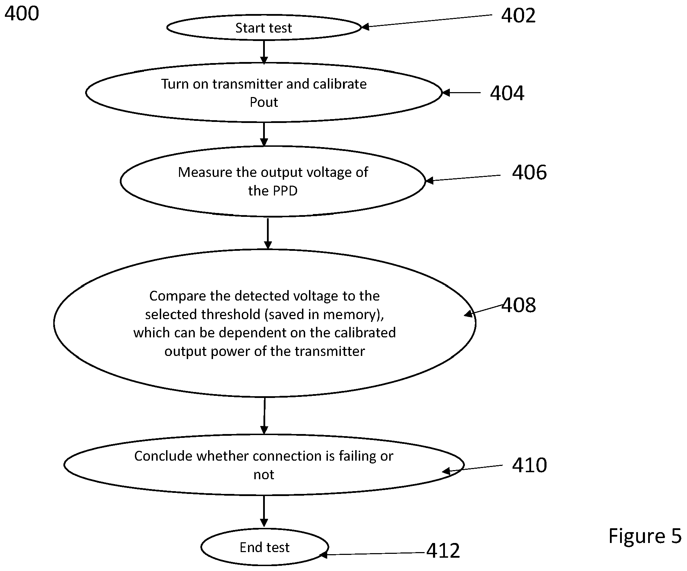

FIG. 5 is a flowchart showing the steps needed perform a safety check of the circuit 200. The method may be performed by any suitable component including, but not limited to components of circuits 200 and 300 of FIGs 2 and 4. It is envisaged that not every operation may be necessary, and some operations may be performed in a different order, or simultaneously, or not even not performed, whilst still falling in the scope of the disclosure.

The method 400 of the safety check has the following operations. At 402, the test is started. At 404, the integrated circuit 202 is turned on, and Pmax is calibrated for the one or more of transmitters 262, 260 as described above with reference to FIG. 2. At this point, the incident signal is calibrated, using the detector circuit 236 at the coupled output of the bi-directional coupler 234. At 406, the output voltage of the detector circuit at the isolated output 238 is measured. At 408 the detected PPD voltage is compared to the selected threshold (that has been saved in memory 254), which can be dependent on the calibrated output power of the transmitter. Various different thresholds may be stored in the memory 254. Each of the stored threshold will be dependent on the calibrated output power. These values will be used as an input for the real time monitor 256, and they will be compared to the detected voltage by the detector circuit 238. In case the detected voltage from the detector circuit 238 exceeds the threshold, a flag will be generated. At 410 a review of the comparison result is performed to conclude whether (or not) a connection between the integrated circuit 202 and the external circuitry is failing. The safety check then ends at 412.

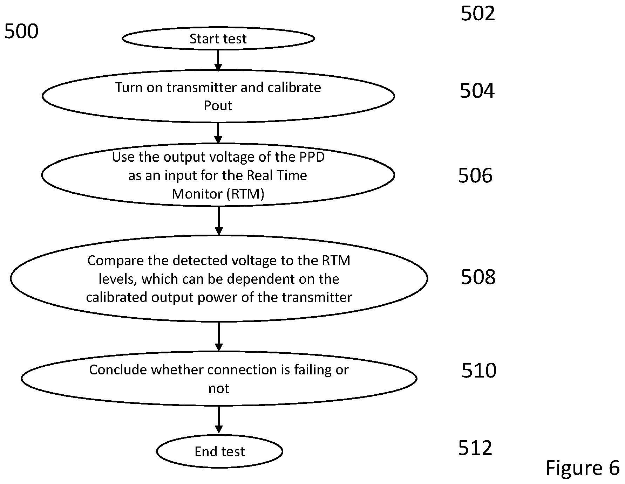

FIG. 6 is a flowchart showing the circuit of FIG. 2 or FIG. 3 in use, and determining if there is a connection failure between the integrated circuit 202 and the external circuitry. The method may be performed by any suitable component including, but not limited to components of circuits 200 and 300 of FIGs 2, and 4. It is envisaged that not every operation may be necessary, and some operations may be performed in a different order, or simultaneously, or not even not performed, whilst still falling in the scope of the disclosure.

The method 500 starts at 502 At 504, the transmitter 202 is turned on, and Pout is calibrated for the transmitter 202, the calibration is as described above with reference to figure 4. At 506, the calibrated output voltage of the detector circuit 236 is used as an input for the Real Time Monitor (RTM) 256. At 508, the voltage of the detector circuit 236 is compared to the RTM levels, which may be dependent on the calibrated output power of the transmitter. At 510, the flowchart determines, based on the measurements whether connection is failing or not. Finally, the method ends at 512.

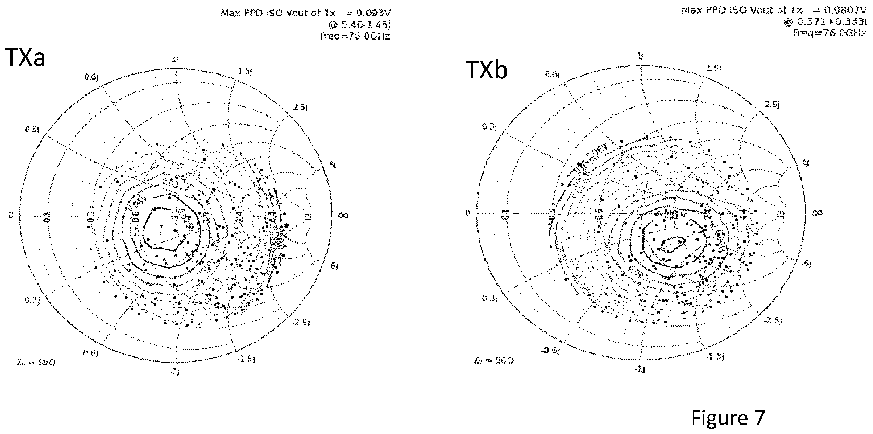

FIG.s 7(a) and 7(b) are example Smith Charts for different channels of transmitter. FIG. 7(a) shows the results for a Max PPD Vout of 0.093V on a transmitter and FIG. 7(b) shows the results for a Max PPD Vout of 0.807V. These voltages are merely examples, and are not representative of all possible circuits. These plots show that the coupler 234 plus the detector are fully functional with varying impedence. A failed connection within the circuit 200 will result in an usually high voltage, which will be shown in these plots. As shown from these figures a connection within the circuit 200 can be deemed as failing when the DC voltage reported by the isolated detector circuit 238 exceeds a target threshold voltage. Preferably the preset target threshold voltage is in the range 80-100mV, but this may be adapted to the calibrated power output. The preset thresholds of 80-100mV are applicable when calibrating for the maximum output power. If the calibrated power is less than Pmax, then the threshold should be smaller than the values mentioned in this scenario. Ultimately, a function needs to be created to establish the relationship between calibrated power and voltage thresholds.

Although examples have been described with reference to a radar unit suitable for an automotive application, it is envisaged that the concepts herein described may be applicable to other applications, such as radar for robotics or drones. Furthermore, it is envisaged that the concepts described herein will be applicable to any RF circuit or device that uses differential signalling lines. Alternatively, the aspects as described may also be used for any communication device that includes an RF combiner for combining the output from two or more output paths. This may include circuitry where a transmitter is connected to external circuitry via connections such as ball bonds or solder joints, and failure of the connection between different circuit connections will be detected in the manner described above.

In the foregoing specification, the invention has been described with reference to specific examples of the invention. It will, however, be evident that various modifications and changes may be made therein without departing from the scope of the invention as set forth in the appended claims and that the claims are not limited to the specific examples described above.

The connections as discussed herein may be any type of connection suitable to transfer signals from or to the respective nodes, units or devices, for example via intermediate devices. Accordingly, unless implied or stated otherwise, the connections may for example be direct connections or indirect connections. The connections may be illustrated or described in reference to being a single connection, a plurality of connections, unidirectional connections, or bidirectional connections. However, different embodiments may vary the implementation of the connections. For example, separate unidirectional connections may be used rather than bidirectional connections and vice versa. Also, plurality of connections may be replaced with a single connection that transfers multiple signals serially or in a time multiplexed manner. Likewise, single connections carrying multiple signals may be separated out into various different connections carrying subsets of these signals. Therefore, many options exist for transferring signals. Those skilled in the art will recognize that the architectures depicted herein are merely exemplary, and that in fact many other architectures can be implemented which achieve the same functionality.

Any arrangement of components to achieve the same functionality is effectively 'associated' such that the desired functionality is achieved. Hence, any two components herein combined to achieve a particular functionality can be seen as 'associated with' each other such that the desired functionality is achieved, irrespective of architectures or intermediary components. Likewise, any two components so associated can also be viewed as being 'operably connected,' or 'operably coupled,' to each other to achieve the desired functionality.

Furthermore, those skilled in the art will recognize that boundaries between the above described operations merely illustrative. The multiple operations may be combined into a single operation, a single operation may be distributed in additional operations and operations may be executed at least partially overlapping in time. Moreover, alternative embodiments may include multiple instances of a particular operation, and the order of operations may be altered in various other embodiments. Also for example, in one embodiment, the illustrated examples may be implemented as circuitry located on a single integrated circuit or within a same device.

In some examples, the various components within the circuitry can be realized in discrete or integrated component form, with an ultimate structure therefore being an application-specific or design selection. As the illustrated embodiments of the present invention may, for the most part, be implemented using electronic components and circuits known to those skilled in the art, details will not be explained in any greater extent than that considered necessary as illustrated below, for the understanding and appreciation of the underlying concepts of the present invention and in order not to obfuscate or distract from the teachings of the present invention. A skilled artisan will appreciate that the level of integration of components may be, in some instances, implementation-dependent.

In the claims, any reference signs placed between parentheses shall not be construed as limiting the claim. The word 'comprising' does not exclude the presence of other elements or steps then those listed in a claim. Furthermore, the terms 'a' or 'an,' as used herein, are defined as one or more than one. Also, the use of introductory phrases such as 'at least one' and 'one or more' in the claims should not be construed to imply that the introduction of another claim element by the indefinite articles 'a' or 'an' limits any particular claim containing such introduced claim element to inventions containing only one such element, even when the same claim includes the introductory phrases 'one or more' or 'at least one' and indefinite articles such as 'a' or 'an.' The same holds true for the use of definite articles.

Unless stated otherwise, terms such as 'first' and 'second' are used to arbitrarily distinguish between the elements such terms describe. Thus, these terms are not necessarily intended to indicate temporal or other prioritization of such elements. The mere fact that certain measures are recited in mutually different claims does not indicate that a combination of these measures cannot be used to advantage.

## Claims

1. A circuit (200) for testing failure of a connection between a radio frequency, RF, integrated circuit and external circuitry, the circuit comprises:
a first amplifier (222) having an input path and an output path;
a second amplifier (228) having an input path and an output path;
a combiner (232) configured to combine signals from the output path of the first amplifier and the output path of the second amplifier;
a coupler (234) configured to receive the output of the combiner; and
a detector circuit (236) coupled to the output of the coupler,
wherein the combiner is configured to send signals to the external circuitry,
wherein the detector circuit is configured to receive a reflected voltage from the external circuitry, and determine that there is a connection failure between the RF circuit and the external circuitry when the reflected voltage exceeds a preset threshold voltage.

2. The circuit (200) as claimed in claim 1 wherein the coupler (234) is a bidirectional coupler.

3. The circuit (200) as claimed in any preceding claim further comprising a first driver (212) coupled to the input of the first amplifier, and a second driver (214) coupled to the input of the second amplifier.

4. The circuit (200) as claimed in claim 3 further comprising a voltage regulator (210) configured to provide a voltage to at least one of the first driver and the first amplifier.

5. The circuit (200) as claimed in claim 4 wherein the voltage regulator (210) is a Low Drop Out voltage regulator.

6. The circuit (200) as claimed in any of claims 3 to 5 further comprising a digital to analogue convertor (216) configured to provide a bias current to at least one of: the second driver, the second amplifier.

7. The circuit (200) as claimed in any of claims 3 to 6 further comprising a control unit (218) configured to control one of more of the first and second drivers and the first and second amplifiers.

8. The circuit (200) of any preceding claim wherein the failure is at least one of: ball break failure, PCB degradation failure, antenna failure, balun failure or external matching elements failure.

9. The circuit (200) of any preceding claim wherein output power of the circuit is calibrated, and the calibration result is used to determine the preset threshold voltage.

10. The circuit (200) of any of claims 1 to 8 wherein the preset threshold voltage for the reflected voltage is at least 80mV.

11. The circuit (200) of any preceding claim wherein the output signals from the first and second amplifiers (222, 228) are simultaneous signals.

12. The circuit (200) of any preceding claim further comprising a real time monitor (256) and a memory, wherein the preset threshold voltage is stored in the memory and provided to the real time monitor.

13. The circuit (200) of claim 12 wherein an output of the real time monitor (256) is provided to an internal safety monitor (258) .

14. The circuit (200) of any of claims 11, 12 or 13 further comprising an ADC configured to provide a second input to the real time monitor (256).

15. A method for testing a connection between a radio frequency, RF, integrated circuit and external circuitry,
the RF integrated circuit (200) comprising:
a first amplifier (222) having first and second input paths and an output path;
a second amplifier (228) having first and second input paths and an output path;
a combiner (232) for combining the signal from the output path of the first amplifier and the output path of the second amplifier;
a coupler for receiving the output of the combiner;
a power detector coupled to the output of the coupler,
wherein said method comprising:
sending signals to the external circuitry by the first and second amplifiers,
receiving, by the power detector, a reflected voltage from the external circuitry and determining if there is a failure connection between the RF circuit and the external circuitry if the reflected voltage exceeds a preset threshold voltage.
